# EUROPEAN PATENT APPLICATION

(11) **EP 3 282 173 A1**
(43) Date of publication of application: **14.02.2018**
(21) Application number: 15888096.3
(22) Date of filing: 24.04.2015
(51) Int. Cl.: F21S 2/00, F21V 29/503, F21V 29/83

(54) **LED ILLUMINATION LAMP WITH INTEGRATED HEAT DISSIPATION STRUCTURE**

(30) Priority: 10.04.2015 CN 201510169705
(71) Applicant: Li, Feng, Shenzhen, Guangdong 518000 (CN)
(72) Inventor: Li, Feng, Shenzhen, Guangdong 518000 (CN)
(74) Representative: Cabinet Chaillot
(86) International application number: PCT/CN2015/000285
(87) International publication number: WO 2016/161539

(57) **Abstract**

An LED lamp contains: a printed circuit board (PCB) (20), an accommodation casing (10), and a closing plate (30). The PCB (20) is housed in the accommodation casing (10), and the closing plate (30) closes the accommodation casing (10). The PCB (20) includes a plurality of LED chips (21) die bonded on the PCB (20) and electrically connected with the PCB (20) by way of gold wires. The accommodation casing (10) includes a hollow area (12) defined on a central portion thereof, and the accommodation casing (10) includes a peripheral zone (11) surrounding the hollow area (12), wherein the hollow area (12) corresponds to an configuration area of the PCB (20) in which the plurality of LED chips (21) are arranged, and the hollow area (12) has multiple grid units (121) corresponding to the plurality of LED chips (21), respectively.

## Description

### FIELD OF THE INVENTION

The present invention relates to an LED lamp which dissipates heat quickly.

### BACKGROUND OF THE INVENTION

A conventional LED lamp is assembled complicatedly and inefficiently.

The LED lamp contains an illumination element welded on a printed circuit board (PCB) and packaged by conductive silver paste, and the PCB is adhered on an aluminum substrate by using thermally conductive adhesive so as to dissipate heat. Furthermore, a heat dissipator is fixed below the aluminum substrate, and a light lens is arranged above the illumination element accommodated in a casing. However, the LED lamp is complicated and cannot remove heat of LED chips of the illumination element quickly.

For example, the LED chips are SMD packaged, in-line packaged or COB packaged so as to dissipate the heat via a solid colloidal crystal, a PCB copper foil, an insulating layer, the aluminum substrate, and the heat dissipator. However, the heat dissipation is inefficient to increase a temperature of the LED lamp over 80 °C, thus reducing service life of the LED lamp.

The present invention has arisen to mitigate and/or obviate the afore-described disadvantages.

### SUMMARY OF THE INVENTION

The primary objective of the present invention is to provide an LED lamp in which each LED chip dissipates heat directly via said each grid unit of the hollow area of the accommodation casing.

Further objective of the present invention is to provide an LED lamp in which the accommodation casing is made of metal so as to remove the heat of said each LED chip quickly, thus prolonging service life of the LED lamp.

Another objective of the present invention is to provide an LED lamp which is simplified so as to reduce production cost.

To obtain above-mentioned objectives, an LED lamp provided by the present invention contains: a printed circuit board (PCB), an accommodation casing, and a closing plate which are stacked and adhered together.

The PCB is housed in the accommodation casing, and the closing plate closes the accommodation casing so that the PCB is fixed between the accommodating casing and the closing plate.

The PCB (20) includes a plurality of LED chips die bonded on multiple fixing positions of the PCB, respectively, and the plurality of LED chips are electrically connected with the PCB by way of gold wires.

The accommodation casing includes a hollow area defined on a central portion thereof, and the accommodation casing includes a peripheral zone surrounding the hollow area, wherein the hollow area corresponds to an configuration area of the PCB in which the plurality of LED chips are arranged, and the hollow area has multiple hollow grid units corresponding to the plurality of LED chips, respectively.

Preferably, a reflective insulation paint layer is sprayed around each of the multiple fixing positions of the PCB.

Preferably, each of the multiple grid units has a top face, a bottom face, and a surrounding zone connecting with the top face and the bottom face.

Preferably, a height of the top face is lower than that of the peripheral zone, and the bottom face contacts with the reflective insulation paint layer of the PCB, wherein the surrounding zone accommodates each of the plurality of LED chips.

Preferably, the surrounding zone has a tilted fence, a first opening defined on a bottom thereof, and a second opening formed on a top thereof, wherein a size of the first opening is less than that of the second opening.

Preferably, the plurality of LED chips are arranged in a rectangle array on the PCB and correspond to the multiple grid units which are arranged in a rectangle array on the accommodation casing, and each of the multiple grid units corresponds to and houses said each of the plurality of LED chips.

Preferably, the plurality of LED chips are arranged in a sector array on the PCB and correspond to the multiple grid units which are arranged in a sector array on the accommodation casing, and each of the multiple grid units corresponds to and houses said each of the plurality of LED chips.

In addition, a thickness of the LED lamp is within 2 mm to 6 mm, and a temperature of the LED lamp is at a temperature of 25°C to 45 °C.

### BRIEF DESCRIPTION OF THE DRAWINGS

FIG. 1 is a perspective view showing the exploded components of an LED lamp according to a first embodiment of the present invention.
FIG. 2 is a perspective view showing the assembly of the LED lamp according to the first embodiment of the present invention.
FIG. 3 is a perspective view showing the assembly of a part of the LED lamp according to the first embodiment of the present invention.
FIG. 4 a perspective view showing the exploded components of a part of an LED lamp according to a second embodiment of the present invention.

### DETAILED DESCRIPTION OF THE PREFERRED EMBODIMENTS

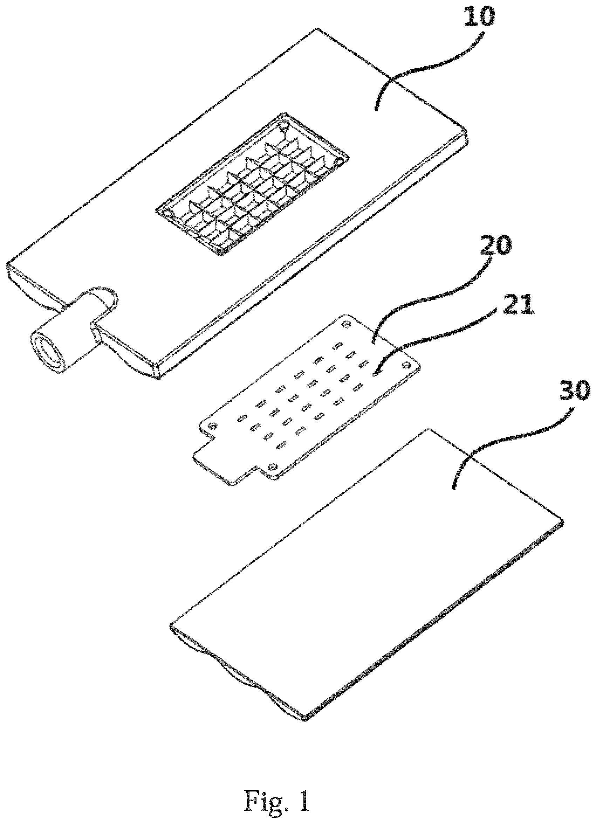

With reference to FIG. 1, an LED lamp according to a first embodiment of the present invention comprises: a printed circuit board (PCB) 20 in a rectangle shape, an accommodation casing 10 in a rectangle shape, and an elongated closing plate 30 which are stacked and adhered together, wherein the PCB 20 is housed in the accommodation casing 10, and the elongated closing plate 30 closes the accommodation casing 10 so that the PCB 20 is fixed between the accommodating casing 10 and the elongated closing plate 30.

The PCB 20 includes a plurality of LED chips 21 die bonded on multiple fixing positions of the PCB 20, respectively, and the plurality of LED chips 21 are electrically connected with the PCB 20 by way of gold wires (not shown), wherein a reflective insulation paint layer is sprayed around each of the multiple fixing positions of the PCB 20, and the gold wires are arranged on the PCB 20 so as to electrically connect the PCB 20 with the plurality of LED chips 21.

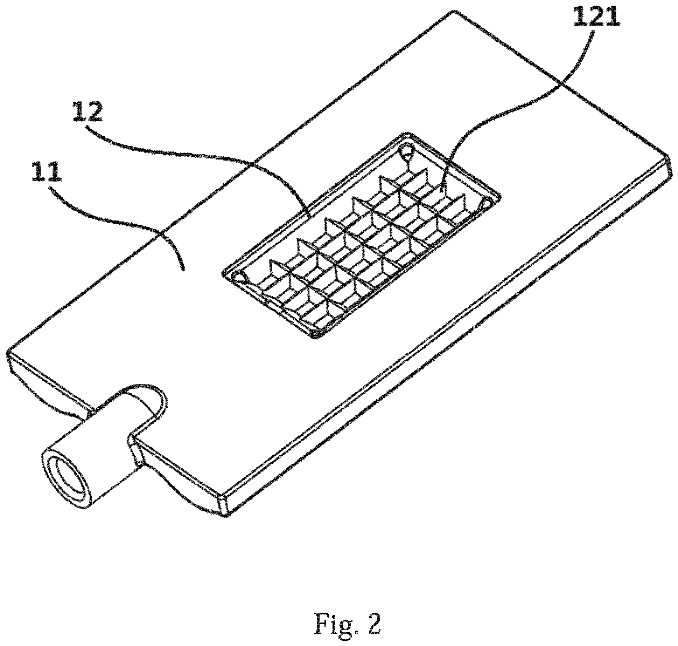

Referring to FIG. 2, the accommodation casing 10 includes a hollow area 12 formed in a rectangle shape and defined on a central portion of the accommodation casing 10, and the accommodation casing 10 includes a peripheral zone 11 surrounding the hollow area 12, wherein the hollow area 12 corresponds to an configuration area of the PCB 20 in which the plurality of LED chips 21 are arranged, and the hollow area 12 has multiple hollow grid units 121 corresponding to the plurality of LED chips 21, respectively.

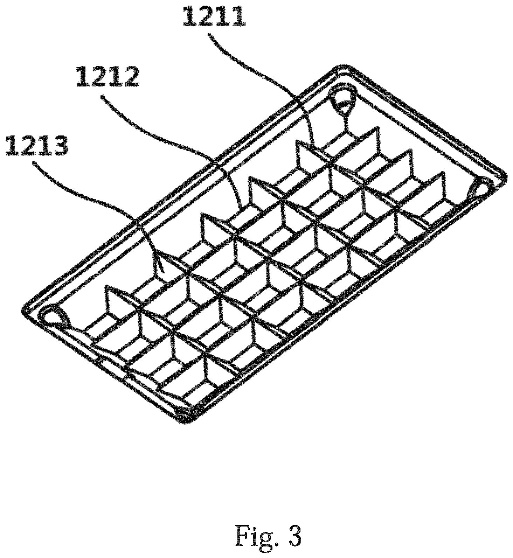

As shown in FIG. 3, each of the multiple grid units 121 has a top face 1211, a bottom face 1212, and a surrounding zone 1213 connecting with the top face 1211 and the bottom face 1212.

A height of the top face 1211 is lower than that of the peripheral zone 11, and the bottom face 1212 contacts with the reflective insulation paint layer of the PCB 20, wherein the surrounding zone 1213 accommodates each of the plurality of LED chips 21.

The surrounding zone 1213 has a tilted fence, a first opening defined on a bottom thereof, and a second opening formed on a top thereof, wherein a size of the first opening is less than that of the second opening.

The plurality of LED chips 21 are arranged in a rectangle array on the PCB 20 and correspond to the multiple grid units 121 which are arranged in a rectangle array on the accommodation casing 10, wherein said each grid unit 121 corresponds to and houses said each LED chip 21.

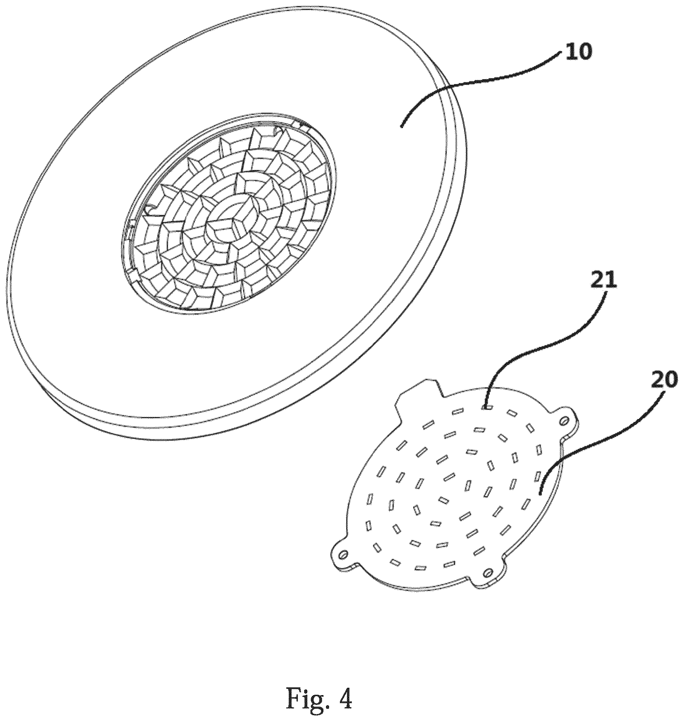

As illustrated in FIG. 4, a difference of an LED lamp of a second embodiment from that of the first embodiment comprises: a printed circuit board (PCB) 20 in a circular disc shape and an accommodation casing 10 in a circular disc shape, wherein a plurality of LED chips 21 are arranged in a sector array on the PCB 20 and correspond to multiple grid units 121 of a hollow area 12 which is formed in a circle shape and defined on a central portion of the accommodation casing 10, wherein the multiple grid units 121 are arranged in a sector array of the accommodation casing 10, and each of the multiple grid units 121 accommodates each of the plurality of LED chips 21.

Thereby, said each LED chip 21 dissipates heat directly via said each grid unit 121 of the hollow area 12 of the accommodation casing 10. Preferably, the accommodation casing 10 is made of metal so as to remove the heat of said each LED chip 21 quickly, thus prolonging service life of the LED lamp.

In addition, a thickness of the LED lamp is within 2 mm to 6 mm, and a temperature of the LED lamp is at a temperature of 25°C to 45 °C.

While the preferred embodiments of the invention have been set forth for the purpose of disclosure, modifications of the disclosed embodiments of the invention as well as other embodiments thereof may occur to those skilled in the art. Accordingly, the appended claims are intended to cover all embodiments which do not depart from the spirit and scope of the invention.

## Claims

1. An LED lamp comprising:
a printed circuit board (PCB) (20), an accommodation casing (10), and a closing plate (30) which are stacked and adhered together;
the PCB (20) being housed in the accommodation casing (10), and the closing plate (30) closing the accommodation casing (10) so that the PCB (20) is fixed between the accommodating casing (10) and the closing plate (30);
the PCB (20) including a plurality of LED chips (21) die bonded on multiple fixing positions of the PCB (20), respectively, and the plurality of LED chips (21) being electrically connected with the PCB (20) by way of gold wires;
**characterized in that**
the accommodation casing (10) includes a hollow area (12) defined on a central portion thereof, and the accommodation casing (10) includes a peripheral zone (11) surrounding the hollow area (12), wherein the hollow area (12) corresponds to an configuration area of the PCB (20) in which the plurality of LED chips (21) are arranged, and the hollow area (12) has multiple hollow grid units (121) corresponding to the plurality of LED chips (21), respectively.

2. The LED lamp as claimed in claim 1, **characterized in that** a reflective insulation paint layer is sprayed around each of the multiple fixing positions of the PCB (20).

3. The LED lamp as claimed in claim 2, **characterized in that** each of the multiple grid units (121) has a top face (1211), a bottom face (1212), and a surrounding zone (1213) connecting with the top face (1211) and the bottom face (1212).

4. The LED lamp as claimed in claim 3, **characterized in that** a height of the top face (1211) is lower than that of the peripheral zone (11), and the bottom face (1212) contacts with the reflective insulation paint layer of the PCB (20), wherein the surrounding zone (1213) accommodates each of the plurality of LED chips (21).

5. The LED lamp as claimed in claim 4, **characterized in that** the surrounding zone (1213) has a tilted fence, a first opening defined on a bottom thereof, and a second opening formed on a top thereof, wherein a size of the first opening is less than that of the second opening.

6. The LED lamp as claimed in claim 1, **characterized in that** the plurality of LED chips (21) are arranged in a rectangle array on the PCB (20) and correspond to the multiple grid units (121) which are arranged in a rectangle array on the accommodation casing (10), and each of the multiple grid units (121) corresponds to and houses said each of the plurality of LED chips (21).

7. The LED lamp as claimed in claim 1, **characterized in that** the plurality of LED chips (21) are arranged in a sector array on the PCB (20) and correspond to the multiple grid units (121) which are arranged in a sector array on the accommodation casing (10), and each of the multiple grid units (121) corresponds to and houses said each of the plurality of LED chips (21).
